(19) Europäisches Patentamt
European Patent Office
Office européen des brevets

(11) **EP 3 942 392 B1**

(12) **FASCICULE DE BREVET EUROPEEN**

(45) Date de publication et mention de la délivrance du brevet:
**29.03.2023 Bulletin 2023/13**

(21) Numéro de dépôt: **20723145.7**

(22) Date de dépôt: **07.05.2020**

(51) Classification Internationale des Brevets (IPC):
*G06F 3/01* (2006.01)  *G06F 3/044* (2006.01)

(52) Classification Coopérative des Brevets (CPC):
**G06F 3/016;** G06F 3/044

(86) Numéro de dépôt international:
**PCT/EP2020/062728**

(87) Numéro de publication internationale:
**WO 2020/225370 (12.11.2020 Gazette 2020/46)**

(54) **INTERFACE TACTILE OFFRANT UN RETOUR VIBROTACTILE A LOCALISATION AMELIOREE**

BERÜHRUNGSSCHNITTSTELLE MIT VERBESSERTER LOKALISIERTER VIBROTAKTILER RÜCKKOPPLUNG

TOUCH INTERFACE OFFERING IMPROVED LOCALISED VIBROTACTILE FEEDBACK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.05.2019 FR 1904756**

(43) Date de publication de la demande:
**26.01.2022 Bulletin 2022/04**

(73) Titulaire: **Commissariat à l'Energie Atomique et aux Energies Alternatives
75015 Paris (FR)**

(72) Inventeurs:
• **BEN DHIAB, Ayoub**
**75014 Paris (FR)**
• **HUDIN, Charles**
**75013 Paris (FR)**

(74) Mandataire: **Brevalex
Tour Trinity
1 Bis Esplanade de La Défense
CS 60347
92035 Paris La Défense Cedex (FR)**

(56) Documents cités:
WO-A1-2018/178582    FR-A1- 3 042 289
GB-A- 2 464 117      US-A1- 2013 318 438
US-A1- 2014 375 602

• HUDIN CHARLES ET AL: "Localized Tactile Feedback on a Transparent Surface through Time-Reversal Wave Focusing", IEEE TRANSACTIONS ON HAPTICS, IEEE, USA, vol. 8, no. 2, 1 avril 2015 (2015-04-01), pages 188-198, XP011584737, ISSN: 1939-1412, DOI: 10.1109/TOH.2015.2411267 [extrait le 2015-06-17]

EP 3 942 392 B1

**Description**

**DOMAINE TECHNIQUE ET ÉTAT DE LA TECHNIQUE ANTÉRIEURE**

La présente invention se rapporte à une interface tactile offrant un retour vibrotactile à localisation améliorée.

Les interfaces tactiles à retour vibrotactile sont utilisées pour les interactions homme-machines. Les interfaces tactiles sont mises en oeuvre dans de nombreux domaines techniques, elles sont par exemple utilisées dans les véhicules automobiles et équipent par exemple les tableaux de bord et/ou consoles centrales et le matériel informatique, tel que les souris d'ordinateur, les claviers d'ordinateur...

Les interfaces tactiles à retour vibrotactile comportent une surface et un ou plusieurs actionneurs qui génèrent des vibrations à travers la surface pour transmettre des informations à un utilisateur, par exemple par l'intermédiaire de l'un ou de plusieurs de ses doigts en contact avec la surface. Lorsque les vibrations sont corrélées aux mouvements du doigt et à la force appliquée par le doigt, l'interface peut simuler un clic, une bosse, une texture.

L'utilisateur peut avoir plusieurs doigts en contact avec la surface tout en ne souhaitant stimuler qu'un seul doigt ou stimuler les doigts différemment pour leur transmettre des informations différentes. Ce type d'interface est désigné interface multicontact ou multitouch.

En outre, il existe des interfaces destinées à être utilisées par plusieurs utilisateurs simultanément, auxquels on souhaite transmettre des informations différentes en générant des vibrations différentes.

Or, la propagation des ondes et les effets de réverbération conduisent généralement à une répartition uniforme de l'énergie vibratoire sur toute la surface. Les actionneurs, agissant comme sources locales de vibrations, produisent une stimulation globale et uniforme. Il n'est alors possible de fournir un retour vibrotactile différent à différentes positions que pour l'exploration d'un seul doigt à travers une variation temporelle corrélée à la position du doigt.

Toute la zone de contact subissant la même vibration, il n'est pas possible, pour des doigts statiques, de générer des variations à une échelle inférieure à la taille des doigts.

Il n'est pas non plus possible de fournir une rétroaction distincte à plusieurs doigts et/ou à plusieurs utilisateurs.

Il existe une interface tactile mettant en oeuvre les fréquences non rayonnantes qui permet de moduler le coefficient de friction entre le doigt et la surface de l'interface de manière localisée. Cependant cela implique un déplacement du doigt. En outre les fréquences non rayonnantes sont des fréquences ultrasonores alors que les fréquences offrant une sensibilité au toucher sont des basses fréquences, généralement inférieures à quelques kilohertz. Par conséquent cette interface tactile n'est pas adaptée à la génération de retours vibrotactiles localisés.

Il existe également des interfaces haptiques mettant en oeuvre des techniques pour localiser les vibrations, qui mettent en forme le champ de vibration, telles que le retournement temporel, le filtrage inverse. Elles utilisent le traitement des signaux et des stratégies de contrôle pour créer de grandes amplitudes de vibrations à certaines positions et les réduire à d'autres. Ces interfaces haptiques offrent une localisation du retour vibrotactile de bonne qualité. Cependant ces techniques impliquent un traitement du signal qui peut être complexe. Le document GB 2 464 117 A décrit une telle interface.

Il existe donc un besoin de proposer une interface tactile présentant un retour vibrotactile localisé comparable aux retours vibrotactiles générées par des interfaces tactiles utilisant par exemple le retournement temporel mais mettant en oeuvre un traitement du signal simplifié.

**EXPOSÉ DE L'INVENTION**

C'est par conséquent un but de la présente invention d'offrir une interface tactile offrant un retour vibrotactile localisé, de réalisation relativement simple par rapport aux interfaces tactiles de l'état de la technique.

C'est également un but de la présente invention d'offrir une interface haptique permettant des interactions multitouch ou multi-utilisateurs performantes.

Les buts énoncés ci-dessus sont atteints par un dispositif comportant un support, au moins un élément présentant une première surface d'interaction, au moins un premier actionneur configuré pour appliquer une vibration audit élément. Le support supporte mécaniquement l'élément de sorte à délimiter une bande dans une première direction. Le module comporte également un module de commande dudit actionneur, configuré pour envoyer des signaux de commande aux instructions à une fréquence inférieure à la fréquence de coupure du premier mode de propagation de l'élément.

Les inventeurs ont déterminé qu'une surface d'interaction de forme allongée supportée mécaniquement au niveau de ses bords de plus grand longueur avait un mode de propagation dont la fréquence de coupure était non nulle, ce qui donnait accès une plage de fréquence non propagatrice permettant, en sélectionnant dans cette plage, une fréquence pour les signaux de commande du ou des actionneurs, de générer une vibration dont la propagation autour de l'actionneur était limitée.

L'application de l'invention à une interface haptique permet d'offrir un retour vibrotactile localisée. L'interface ainsi réalisée est donc utilisable en tant qu'interface multitouch et/ou multiutilisateur.

De manière préférée, la longueur de l'élément est au moins 2 à 3 fois supérieure à sa largeur.

L'élément est par exemple simplement supporté et/ou encastré au niveau de ses bords latéraux.

Dans un exemple de réalisation, l'interface comporte une plaque en forme de bande, ses bords latéraux étant supportés par le support.

Dans un autre exemple, l'interface comporte une plaque et le support supporte la plaque de sorte à délimiter des bandes parallèles.

La présente invention a alors pour objet une interface haptique comportant un support, au moins une plaque comprenant une première face formant une surface d'interaction avec au moins un organe d'un utilisateur, et au moins un actionneur apte à appliquer une vibration à ladite plaque, et un module de commande dudit actionneur. Ledit support comporte au moins deux éléments supports supportant la plaque de sorte à délimiter entre les deux éléments supports une bande s'étendant sensiblement le long d'une première direction, ledit actionneur étant situé à l'opposé de la plaque par rapport à la surface d'interaction. Ledit module de commande est configuré pour générer des signaux de commande audit actionneur à des premières fréquences inférieures à la fréquence de coupure du premier mode de propagation de ladite plaque, de sorte que l'actionneur génère des ondes évanescentes dans la plaque.

De préférence, la plaque présente une première dimension dans la première direction et dans laquelle la distance entre les deux éléments supports est au moins deux fois plus petite que la première dimension. Par exemple, la plaque présente une deuxième dimension dans une direction orthogonale à la première direction entre ses bords latéraux, et les éléments supports supportent les bords latéraux, la première dimension étant au moins deux fois plus grande que la deuxième dimension.

La plaque peut être simplement supportée par le support et/ou encastrée au support.

Dans un exemple de réalisation, la plaque est collée sur le support.

Selon une caractéristique additionnelle, la ou les fréquences des signaux de commande sont comprises entre 0 Hz et quelques kHz.

L'interface haptique peut comporter au moins deux actionneurs répartis le long de la première direction.

Dans un exemple de réalisation, le support comporte au moins trois éléments supports de sorte à délimiter au moins deux bandes dans la plaque dans la première direction, et dans laquelle au moins un actionneur est situé au droit de chaque bande.

Selon une caractéristique additionnelle, l'interface haptique comporte des moyens de détection pour détecter la position dudit au moins un organe et le module de commande est configuré pour générer les signaux de commande en en prenant en compte les signaux émis par les moyens de détection.

Selon une autre caractéristique additionnelle, l'interface haptique comporte des moyens de mesure pour mesurer un effort exercé par ledit au moins un organe sur la surface d'interaction et le module de commande est configuré pour générer les signaux de commande en prenant en compte les signaux émis par les moyens de mesure.

L'interface peut comporter plusieurs actionneurs et le module de commande est configuré pour générer des signaux de commande pour chaque actionneur individuellement.

Dans un exemple de réalisation, le module de commande est configuré pour générer des signaux de commande combinant les signaux de commande aux premières fréquences et des signaux de commande à des deuxièmes fréquences non radiatives.

Selon une caractéristique additionnelle, l'interface haptique comporte. un écran disposé sous la plaque à l'opposé de la surface d'interaction, ledit au moins un actionneur étant entre la plaque et l'écran, ledit au moins un actionneur étant un actionneur piézoélectrique comportant des films minces transparents.

En variante, l'écran est fixé à la plaque à l'opposé de la surface interaction, ledit écran étant interposé entre la plaque et ledit au moins un actionneur.

La présente invention a également pour objet un clavier d'ordinateur comportant des touches et au moins une interface haptique selon l'invention.

La présente invention a également pour objet une souris d'ordinateur comportant au moins une interface haptique selon l'invention, ladite interface haptique étant configurée pour simuler au moins un clic.

## BRÈVE DESCRIPTION DES DESSINS

La présente invention sera mieux comprise sur la base de la description qui va suivre et des dessins en annexe sur lesquels :

La figure 1 est un vue en perspective d'un exemple de réalisation d'une interface haptique à retour vibrotactile,
La figure 2 est une représentation graphique du déplacement en dB calculé de la plaque en fonction de la fréquence au centre de l'actionneur (I) et à un point P distant du centre de l'actionneur (II) pour un exemple d'interface haptique comportant un actionneur,

La figure 3 est une représentation graphique du déplacement mesuré en dB de la plaque en fonction de la fréquence au centre de l'actionneur (I') et à un point P distant du centre de l'actionneur (II') pour un autre exemple d'interface haptique comportant un actionneur,

La figure 4 est une représentation graphique du déplacement en $\mu$m de la plaque le long de l'axe X pour un autre exemple d'interface haptique comportant deux actionneurs,

Les figures 5 et 6 sont des représentations graphiques du déplacement en $\mu$m de la plaque le long de l'axe X pour deux exemples d'interface haptique comportant un actionneur piézoélectrique de forme rectangulaire et un actionneur à masse excentrée respectivement,

Les figures 7A et 7B sont des vues de dessus et de côté, respectivement, d'un exemple d'interface haptique comportant une pluralité d'actionneurs de forme rectangulaire,

Les figures 8A et 8B sont des vues de dessus et de côté, respectivement, d'un exemple d'interface haptique bidimensionnelle,

Les figures 9, 10, 11 et 12 sont des vues de côté de différents exemples d'empilement pour interface haptique,

Les figures 13A et 13B sont des représentations schématiques d'autres exemples d'interfaces haptique,

La figure 14 est une représentation schématique d'un exemple d'interface haptique dans lequel la plaque et le support sont d'un seul tenant.

## EXPOSÉ DÉTAILLÉ DE MODES DE RÉALISATION PARTICULIERS

Dans la description qui va suivre, il est considéré que l'utilisateur interagit avec l'interface tactile avec ses doigts. Il sera compris qu'il pourrait interagir avec d'autres parties de son corps.

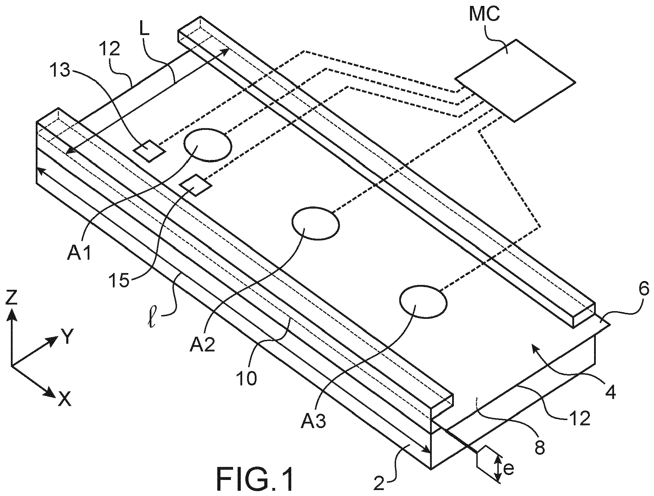

Sur la figure 1, on peut voir un exemple de réalisation d'une interface haptique représenté schématiquement.

L'interface haptique comporte un support ou châssis 2 et un élément ou plaque 4 supporté mécaniquement par le châssis 2.

La plaque 4 comporte une première face 6 avec laquelle l'utilisateur est destiné à interagir, par exemple en positionnant un ou plusieurs doigts sur celle-ci. Cette première face est désignée « surface tactile ».

La plaque 4 comporte une deuxième face 8 opposée à la première face 6.

La plaque comporte des bords latéraux 10 en contact avec le châssis 2 et des extrémités 12 reliant les bords latéraux 10.

Les première 6 et deuxième 8 faces sont séparées d'une distance e. Les bords latéraux 10 sont séparés par une distance L ou largeur, et les extrémités 12 sont séparées d'une distance I ou longueur, la distance I étant supérieure à la distance L.

La longueur I s'étend dans la direction X, la largeur L s'étend dans la direction Y et l'épaisseur e s'étend dans la direction Z.

La forme de la plaque est choisie de sorte que la plaque présente les propriétés géométriques d'un guide d'onde. On entend par « guide d'onde » un milieu où la propagation de l'onde est limitée dans deux directions de l'espace et libre dans la troisième direction. Dans l'exemple représenté, la direction de propagation libre est la direction X.

Par exemple, la longueur I de la plaque est au moins 2 fois supérieure à sa largeur, de préférence au moins 3 fois supérieure à sa largeur L.

Dans l'exemple représenté sur la figure 1, la plaque 4 a la forme d'un rectangle mais cette forme n'est pas limitative, toute forme présentant une longueur plus grande que sa largeur et son épaisseur entre dans le cadre de la présente invention.

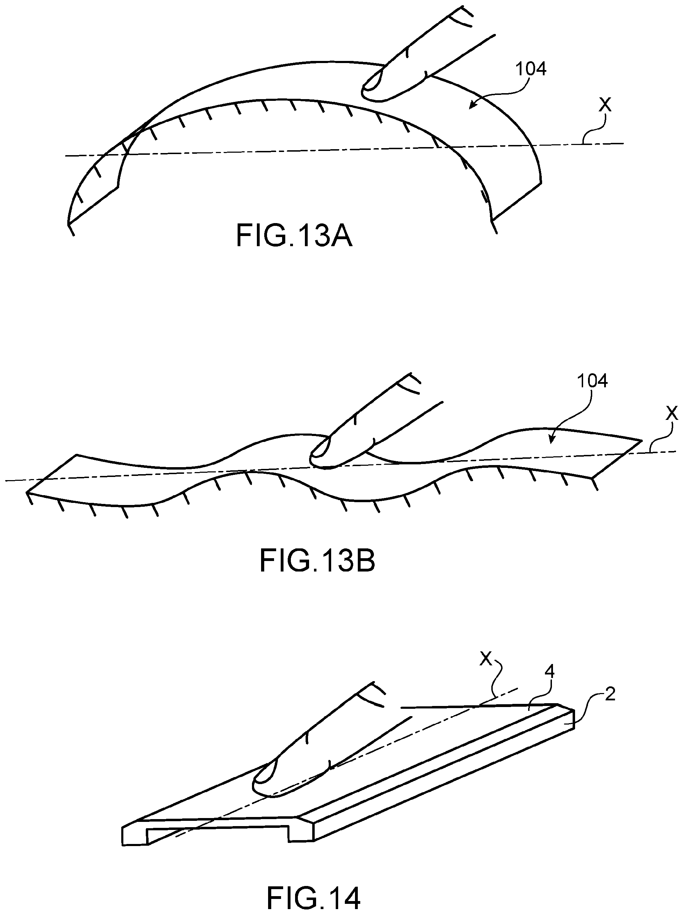

Par exemple sur les figures 13A et 13B, on peut voir des exemples d'interfaces comportant des plaques 104 présentant une forme courbe. La plaque s'étend dans les 3 dimensions. Le châssis est alors adapté à la forme de la plaque.

En outre la bande peut être ondulée dans le plan. Ainsi la bande n'est pas rectiligne, néanmoins elle s'étend sensiblement dans la direction X.

La plaque peut être en un matériau unique homogène et isotrope ou non. Le matériau de la plaque peut être choisi, par exemple parmi le métal, le verre, le plastique ou un matériau composite. La plaque peut comporter un assemblage de couches solidaires les unes des autres. En variante, la plaque comporte un écran composé d'un afficheur, de son rétro éclairage et de sa couche tactile. En variante encore la plaque comporte un afficheur à diode électroluminescente organique ou OLED (Organic Light-Emitting Diode en terminologie anglo-saxonne) ou de type papier électronique (epaper en terminologie anglo-saxonne) seul ou superposé à un support rigide.

L'interface comporte un ou plusieurs actionneurs A1, A2, A3, trois dans l'exemple représenté disposés sous la plaque et destinés à venir en contact avec la deuxième face 8 pour lui appliquer une vibration. Les actionneurs sont localisés sous la plaque 4 au droit des zones où l'on souhaite générer une stimulation vibrotactile. Dans l'exemple représenté, les actionneurs A1, A2, A3 sont alignés le long de l'axe X.

Les actionneurs peuvent être de différents types, par exemple des actionneurs piézoélectriques, des actionneurs électromagnétiques, des actionneurs à masse excentrée ou des actionneurs linéaires résonants ou LRA (Linear Resonant Actuator en terminologie anglo-saxonne).

Ces types d'actionneur sont bien connus dans le domaine des interfaces haptiques et ne seront pas décrits en détail. Les dimensions des actionneurs sont typiquement de l'ordre du cm. On peut avantageusement utiliser des actionneurs piézoélectriques dont la largeur est du même ordre que celle de la plaque. Une densité maximale d'actionneurs permettant d'actionner chaque point individuellement peut être obtenue en assemblant les actionneurs bord à bord.

En outre, les actionneurs peuvent être de taille et de forme différentes les uns par rapport aux autres.

La plaque 4 est supportée mécaniquement par le châssis 2. On entend par « supportée mécaniquement » dans la présente demande, « simplement supportée », « encastrée » ou « en partie simplement supportée et en partie encastrée ».

Une plaque simplement supportée au niveau de ses bords latéraux est une plaque qui repose par ses bords latéraux sur le châssis de sorte que ses bords latéraux puissent fléchir sans qu'ils en soient empêchés.

Concernant les extrémités 12 de la plaque 4, celles-ci peuvent être libres ou maintenues sur le châssis.

Dans l'exemple représenté sur la figure 1, les bords latéraux 10 sont encastrés.

En variante, la plaque est collée sur le châssis, une telle liaison par collage correspond mécaniquement à une liaison en partie supportée et en partie encastrée.

Selon une autre variante représentée sur la figure 14, la plaque 4 et le châssis sont d'un seul tenant. La surface peut être considérée comme encastrée dans son support.

L'interface comporte également un module de commande M destiné à générer des signaux de commande à chaque actionneur de sorte qu'ils appliquent à la plaque des vibrations ayant des caractéristiques données. Le module de commande commande de préférence chaque actionneur indépendamment permettant ainsi une interaction riche.

Les signaux de commande sont choisis de sorte à présenter des fréquences inférieures à la fréquence du premier mode de propagation de la plaque supportée par le châssis.

Nous allons expliquer comment ces fréquences sont choisies.

Dans l'interface haptique de la figure 1, la plaque 4 forme un milieu de propagation des ondes vibratoires, assimilable à un guide d'onde, i.e. ayant une épaisseur et une largeur finies mais avec une longueur arbitraire. La propagation des ondes dans un guide d'ondes peut être décrite en termes de modes de propagation. Chacun de ces modes est défini par son profil, sa vitesse d'onde et sa fréquence de coupure.

Dans le cas d'une plaque simplement supportée ou encastrée, le mode zéro a une amplitude nulle et ne contribue pas à la propagation. Par conséquent, les ondes de flexion ne peuvent pas se propager dans ce guide en dessous de la fréquence de coupure du premier mode de propagation, alors que dans la plupart des guides d'ondes le mode de propagation d'ordre zéro, avec une fréquence de coupure égale à 0 Hz existe.

Les inventeurs ont établi l'expression suivante reliant l'amplitude des vibrations en fonction de la fréquence.

$$u(x, y, t) = \left( \sum_{n=1}^{\infty} A_n \sin(q_n y) e^{-jp_n x} \right) e^{j\omega t} \quad (1)$$

avec :

$$q_n = \frac{n\pi}{W}$$

$$p_n = \left( \frac{\rho h}{D} \right)^{\frac{1}{4}} \sqrt{\omega - \omega_n}$$

$$\omega_n = \sqrt{\frac{D}{\rho h}} \left( \frac{n\pi}{W} \right)^2$$

où :

$A_n$: l'amplitude complexe pour chaque mode,
$W$ : la largeur de la plaque,
$\rho$ : la masse volumique,

*h* : l'épaisseur de la plaque,

*D*: la rigidité à la flexion.

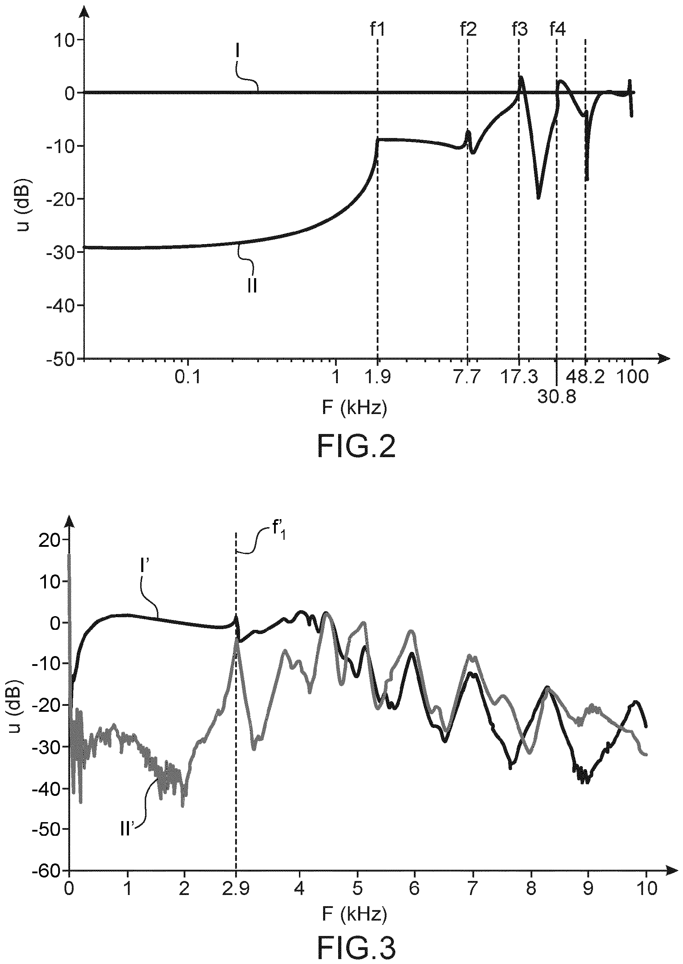

La figure 2 représente la variation de l'amplitude u des vibrations en dB, calculée à partir de la formule (1), en fonction de la fréquence F en kHz au centre de l'actionneur et en un point P distant de l'actionneur d'une distance de 20 mm sur l'axe X et d'une distance de W/6 sur l'axe Y, pour une interface haptique ayant les propriétés suivantes : l'interface comporte une plaque de largeur W = 25 mm, d'épaisseur h = 0,5 mm. Elle est en aluminium, le coefficient de poisson v = 0,346, le module d'Young E = 67 MPa, $\rho$ = 2700 kg/m²) et une amplitude An = 1. L'interface comporte un actionneur.

L'amplitude au centre de l'actionneur est prise comme référence et est représentée par la courbe I et l'amplitude au point P est représentée par la courbe II.

On peut observer les modes de propagation d'ordre 1 à 4 et leurs fréquences de coupure respectives f1, f2, f3, f4.

On constate que, pour la gamme de fréquence entre 0 Hz et f1, l'amplitude des ondes de vibration diminue exponentiellement avec la distance à la source, les ondes générées à ces fréquences sont donc des ondes évanescentes, i.e. qui ne se propagent pas. En outre f1 = 1,9 kHz. Or les fréquences auxquelles l'être humain est sensible au toucher sont comprises entre 0 et 1 kHz. Il est donc possible de sélectionner une fréquence inférieure à f1 et à laquelle l'utilisateur sera sensible par le toucher, pour générer des signaux de commande aux actionneurs, et générer des vibrations détectables par l'utilisateur localisées au niveau des actionneurs. On produit donc un retour vibrotactile localisé.

Il est donc possible d'offrir simultanément, dans le cas d'une interface à plusieurs actionneurs, des rétroactions vibrotactiles localisées dans la plaque à différentes fréquences comprises dans l'intervalle [0 Hz ; f1].

La fréquence de coupure peut atteindre 1 kHz qui est la limite haute de sensibilité tactile, voire 10 kHz. La ou les fréquences des signaux de commande sont donc comprises entre 0 kHz et 10 kHz.

Sur la figure 3, on peut voir la variation d'amplitude en fonction de la fréquence mesurée au centre de l'actionneur et au point P sur une interface haptique réelle à l'aide d'un vibromètre en contact avec la surface tactile.

L'interface haptique a les caractéristiques suivantes : elle comporte une plaque en aluminium avec un actionneur piézoélectrique collé au centre de la face inférieure. L'actionneur modèle muRata®7BB-20-3, de géométrie circulaire, comporte une plaque de diamètre 20 mm et d'épaisseur de 0,1 mm et une électrode de diamètre 12,8 mm et d'épaisseur 0,11 mm. La plaque, mesurant $25 \times 200 \times 0,5$ *mm*³, est fixée sur ses côtés les plus longs à un cadre rigide à l'aide de résine époxy et laissée libre aux deux extrémités. Le déplacement hors plan de la surface est mesuré par un vibromètre laser modèle Polytec® OFV-534/2570.

La courbe I' représente l'amplitude en dB au centre de l'actionneur et II' l'amplitude en dB au point P en fonction de la fréquence F en kHz. On observe une gamme de fréquence non propagative entre 0 et f1' = 2,9 kHz, et une amplitude au droit du centre de l'actionneur environ 30 dB plus grande que dans des zones éloignées de l'actionneur.

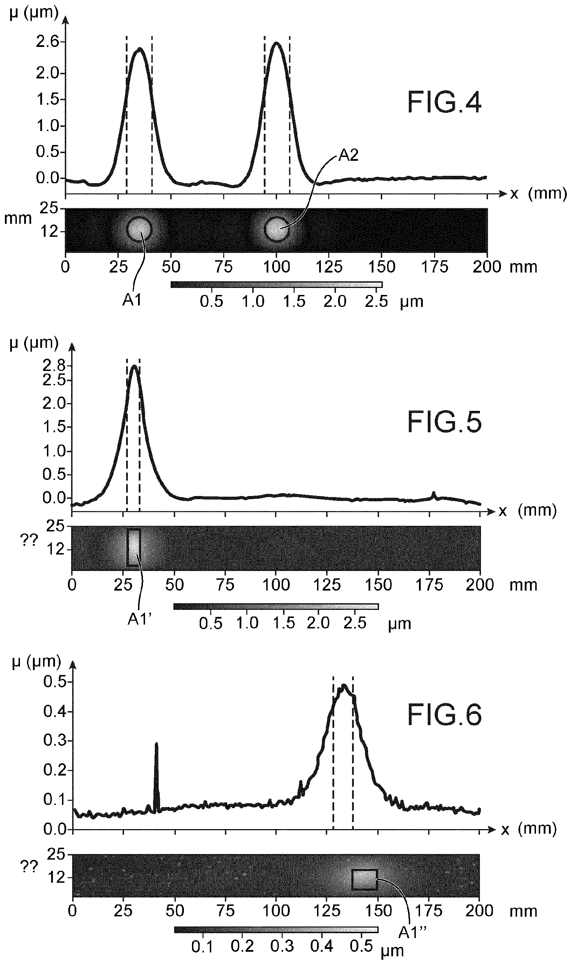

Sur la figure 4, on peut voir la variation de l'amplitude u du déplacement en $\mu$m mesurée à travers la plaque en fonction de la position x en mm le long de la direction X en excitant deux actionneurs A1, A2 à des fréquences inférieures à f1. On constate que seules les zones au droit des actionneurs sont déplacées sensiblement (amplitude de 2,6 $\mu$m) de sorte à générer un retour vibrotactile à l'utilisateur, alors que le reste de la surface tactile est quasiment immobile. Une utilisation multitouch et/ou multiutilisateur est donc rendue possible grâce à l'invention.

Sur la figure 5, on peut voir la variation de l'amplitude u du déplacement en $\mu$m en fonction de la position x en mm le long de la direction X pour une interface haptique comportant un actionneur piézoélectrique A1' de forme rectangulaire de dimensions $18 \times 6 \times 0,25$ mm³, les plus grands côtés étant parallèles à la direction Y.

Sur la figure 6, on peut voir la variation de l'amplitude u du déplacement en $\mu$m en fonction de la position x en mm le long de la direction X pour une interface haptique comportant un actionneur A1" à masse excentrée présentant une surface de d'interaction 6 avec la plaque de $10 \times 10$ mm².

On constate la localisation du retour vibrotactile à la zone au droit de l'actionneur.

Les signaux de commande peuvent être une tension continue dans le cas d'actionneurs à masse excentrée, une sinusoïde à la fréquence de résonance d'un actionneur des actionneurs résonants résonant type LRA ou un signal arbitraire de bande passante inférieure à la fréquence de coupure du premier mode dans le cas d'actionneurs électromagnétiques ou piézoélectriques.

La précision de la localisation du retour vibrotactile peut être réglée en choisissant les dimensions des actionneurs, les dimensions de la plaque, notamment la largeur de la plaque et son matériau. Les inventeurs ont constaté que la vitesse à laquelle les vibrations s'atténuaient autour de l'actionneur était inversement proportionnelle à la largeur de la plaque. Plus les actionneurs sont petits plus la zone où les vibrations seront générées pourra être petite.

De manière avantageuse, l'interface peut comporter des moyens de détection 13 pour détecter la position du ou des doigts et/ou des moyens de mesure 15 de l'effort exercé par celui-ci ou ceux -ci sur la surface. Ainsi il est possible de moduler le retour vibrotactile en fonction de la position des doigts ou des efforts exercés sur la surface. Le retour vibrotactile peut alors n'être activé que lorsque la présence d'un doigt en contact avec la surface tactile au droit d'un actionneur est détectée, en résulte alors une réduction de l'énergie consommée pour faire fonctionner l'interface tactile.

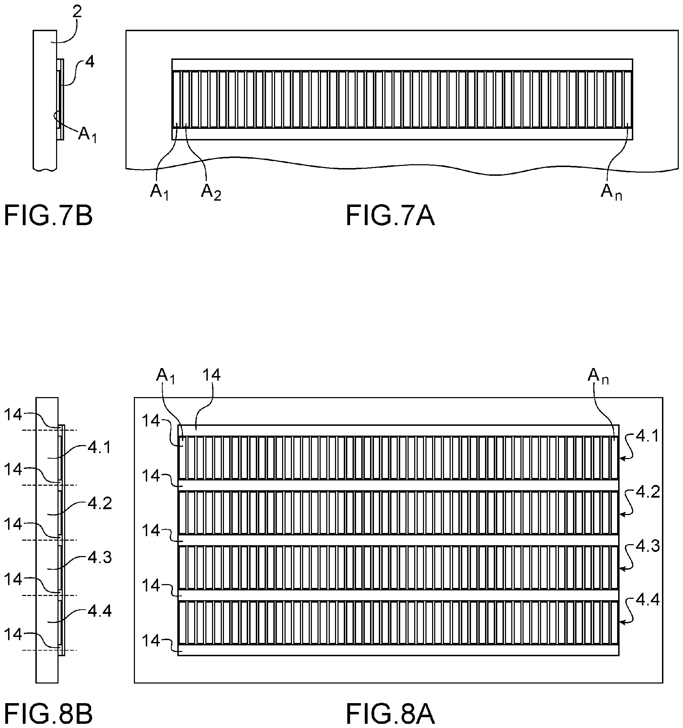

Il sera compris qu'un doigt peut entrer en contact avec plusieurs actionneurs en fonction de la taille de ceux-ci et qu'ils peuvent être commandés pour produire le même retour haptique. Par exemple sur les figures 7A et 8A, les actionneurs sont très étroits, il est donc probable que la pulpe d'un doigt recouvre au moins deux actionneurs. En variante, on peut envisager au contraire qu'ils génèrent des retours vibrotactiles différents.

De manière avantageuse, on peut combiner la génération d'un retour vibrotactile basse fréquence selon l'invention, par exemple pour simuler un clic, et un modulation de friction pour simuler une texture en utilisant des fréquences non rayonnantes qui sont des fréquences ultrasonores, tel que cela est décrit dans le document C. Hudin, "Local friction modulation using non-radiating ultrasonic vibrations," in IEEE World Haptics Conférence, Fürstenfeldbruck (Munich), Germany, 2017. Le module de commande génère alors des signaux de commande complexes combinant des signaux à basse fréquence et des signaux à fréquence non rayonnante.

En outre, dans le cas où l'on génère également des vibrations pour simuler une texture, le suivi du déplacement du doigt permet avantageusement de donner l'illusion d'une texture plus fine que la dimension de l'actionneur lui-même.

Selon un exemple de réalisation, la détection de la présence d'un doigt peut être obtenue par des moyens capacitifs. Le doigt et l'électrode supérieure de l'actionneur forment les deux électrodes d'un condensateur plan séparées par une plaque isolante intermédiaire. En outre il est possible d'utiliser ces moyens pour suivre le déplacement des doigts.

Selon un autre exemple, la détection de la présence d'un doigt peut être réalisée en mesurant une variation d'impédance électrique du matériau piézoélectrique de l'actionneur. Cette détection est peu précise mais est néanmoins suffisante pour mettre en oeuvre la présente invention.

En variante, plusieurs actionneurs sont mis en oeuvre un niveau d'une zone de retour vibrotactile, par exemple pour générer un retour vibrotactile d'amplitude plus grande.

Sur les figures 7A et 7B, on peut voir un autre exemple de réalisation d'une interface haptique à retour vibrotactile comportant une pluralité d'actionneurs piézoélectriques A1, A2....An de forme rectangulaire dont la longueur est alignée avec l'axe Y.

Sur la figure 7B, on peut voir la plaque 4 supportée par le châssis 2.

Sur les figures 8A et 8B, on peut voir un exemple de réalisation d'une interface haptique bidimensionnelle comportant une plaque 4 avec des encastrements de sorte à délimiter des bandes étroites 4.1, 4.2, 4.3, 4.4 juxtaposées. La plaque est alors divisée en plusieurs guides d'onde.

Comme cela est visible sur la figure 8B, les bords latéraux de chaque bande sont supportés par le châssis. Dans cet exemple le châssis comporte des saillies linéaires 14 le long de la direction Z, s'étendant dans la direction X supportant chacune deux bords latéraux de deux plaques adjacentes. En variante, le châssis comporte autant de saillies linéaires que de bords latéraux à supporter.

Du fait de l'encastrement, la vibration ne peut se propager d'une bande à l'autre.

En variante, l'interface comporte plusieurs plaques étroites juxtaposées, chaque plaque étant indépendante mécaniquement des autres plaques et étant supportée par ses bords latéraux. Dans cette variante, la surface de contact n'est pas continue entre les différentes plaques.

Le ou les utilisateurs peuvent interagir avec plusieurs plaques et en plusieurs endroits de la plaque simultanément.

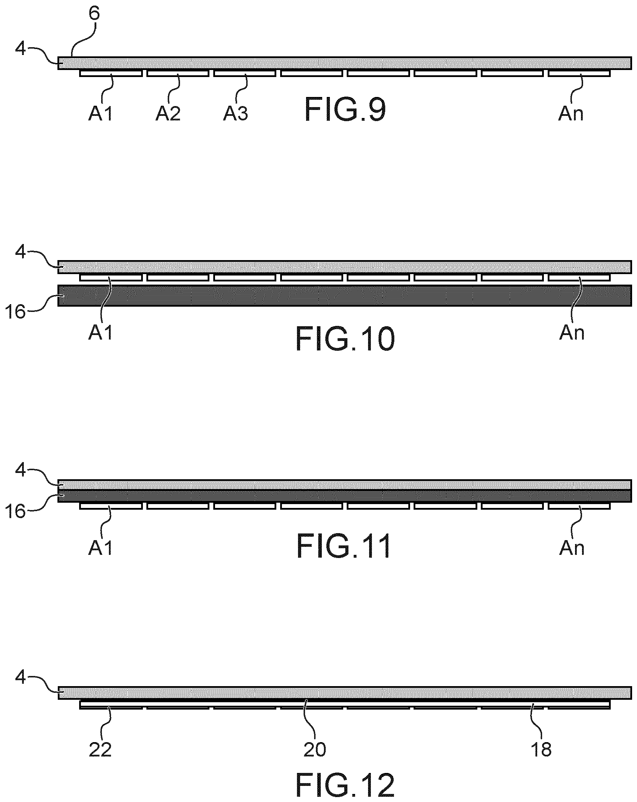

Sur les figures 9 à 11, on peut voir des vues de côté de différents exemples d'empilement pour une interface haptique selon l'invention.

Sur la figure 9, on peut voir un exemple de réalisation de pavé tactile. La plaque 4 formant la surface tactile n'est pas transparente. Les actionneurs A1...An sont situés directement sous la plaque.

Sur les figures 10 et 11, un écran est associé à l'interface haptique par exemple pour afficher des icônes aux emplacements des actionneurs et/ou tout autre visuels correspondant au message à transmettre par stimulation vibrotactile, par exemple une bouton marche/arrêt associé à un clic ou une barre de son associé à des crans.

Sur la figure 10, il s'agit d'une application à un écran tactile. Dans cet exemple, un ensemble similaire à celui de la figure 9 est disposé sur un écran 16. La plaque 4 et les actionneurs A1,...An sont réalisés de sorte à être transparents. Par exemple, pour les actionneurs, il peut s'agir d'actionneurs piézoélectriques déposés en couche mince sur la deuxième face de la plaque 4.

Sur la figure 11, l'écran 16 est fixé à la deuxième face de la plaque 4 qui est transparente, et les actionneurs sont situés sous l'écran à l'opposé de la plaque et auquel ils appliquent les vibrations. L'écran 16 se déforme et transmet les vibrations à la plaque. Dans cet exemple, les actionneurs A1...An peuvent ne pas être transparents. On utilise par exemple des colles d'assemblage transparentes pour supporter la plaque, ces colles sont appelées OCA (Optically Clear Adhesive).

Les plaques restent indépendantes mécaniquement les unes des autres de sorte à ne pas modifier les modes de propagation et que la ou les fréquences choisies pour les signaux de commande génèrent effectivement des ondes évanescentes.

Dans les exemples des figures 9, 10 et 11 les actionneurs piézoélectriques sont indépendants les uns des autres, les matériaux piézoélectriques étant déposés de manière discrète.

En variante sur la figure 12, les actionneurs piézoélectriques comportent une couche de matériau piézoélectrique 18 commune à tous les actionneurs, une électrode commune 20 recouvrant une face du matériau piézoélectrique 18 et une pluralité d'électrodes 22 formées sur l'autre face de la couche 18 et définissant chacune des actionneurs.

Le module de commande comporte par exemple une base de données de motifs vibrotactiles que chaque actionneur peut générer. Tout ou partie des actionneurs peut générer toujours ou le même motif ou générer des motifs différents, par exemple en fonction d'un affichage et/ou des signaux extérieurs, tels que la force exercée par l'utilisateur, la vitesse de déplacement du doigt sur la surface.... Cela peut être le cas lorsque l'interface haptique selon l'invention est utilisée pour réaliser des barres de commande pour ordinateur programmables, par exemple situées dans la partie supérieure du clavier offrant un retour haptique vibrotactile, par exemple pour simuler des clics, auquel il est avantageusement associé une simulation de texture par lubrification ultrasonique comme cela a été décrit ci-dessus. Les motifs vibrotactile évoluent en fonction de l'affichage.

L'interface haptique peut être mise en oeuvre dans une souris pour ordinateur, par exemple à la place de la roulette. L'interface haptique peut former un pavé tactile qui permet le défilement avec un retour vibrotactile. Grâce à l'invention, le retour haptique est enrichi par rapport aux dispositifs de l'état de la technique, en effet elle permet de simuler le clic et de simuler le défilement en simulant une texture.

L'interface haptique selon l'invention peut être appliquée à un dispositif de tests psychophysiques sur les seuils des perceptions tactiles par exemple.

Le dispositif selon l'invention présente également l'avantage de ne pas être limité en taille, il peut être fabriqué sur une large gamme de dimensions, il peut être utilisé pour réaliser un dispositif à l'échelle d'un doigt, tel qu'une souris d'ordinateur ou jusqu'à une surface tactile multitouch et multi-utilisateur.

## Revendications

1. Interface haptique comportant un support (2), au moins une plaque (4) comprenant une première face formant une surface d'interaction (6) avec au moins un organe d'un utilisateur, et au moins un actionneur (A1) apte à appliquer une vibration à ladite plaque (4), et un module de commande (MC) dudit actionneur,

   - ledit support comportant au moins deux éléments supports supportant la plaque de sorte à délimiter entre les deux éléments supports une bande s'étendant sensiblement le long d'une première direction (X),
   - ledit actionneur (A1) étant situé à l'opposé de la plaque (4) par rapport à la surface d'interaction (6),
   - ledit module de commande (MC) étant configuré pour générer des signaux de commande audit actionneur (A1) à des premières fréquences inférieures à la fréquence de coupure du premier mode de propagation de ladite plaque, de sorte que l'actionneur (A1) génère des ondes évanescentes dans la plaque (4).

2. Interface haptique selon la revendication 1, dans laquelle la plaque (4) présente une première dimension (I) dans la première direction (X) et dans laquelle la distance entre les deux éléments supports est au moins deux fois plus petite que la première dimension (I).

3. Interface haptique selon la revendication 2, dans laquelle la plaque (4) présente une deuxième dimension (L) dans une direction orthogonale à la première direction (X) entre ses bords latéraux, et dans laquelle les éléments supports supportent les bords latéraux, la première dimension (I) étant au moins deux fois plus grande que la deuxième dimension (L).

4. Interface haptique selon l'une des revendications 1 à 3, dans laquelle la plaque (4) est simplement supportée par le support (2) et/ou encastrée au support (2).

5. Interface haptique selon l'une des revendications 1 à 4, dans laquelle la plaque est collée sur le support (2).

6. Interface haptique selon l'une des revendications 1 à 5, dans laquelle la ou les fréquences des signaux de commande sont comprises entre 0 Hz et 10 kHz.

7. Interface haptique selon l'une des revendications 1 à 6, comportant au moins deux actionneurs répartis le long de la première direction (X).

8. Interface haptique selon l'une des revendications 1 à 7, dans laquelle le support comporte au moins trois éléments supports de sorte à délimiter au moins deux bandes dans la plaque dans la première direction (X), et dans laquelle au moins un actionneur est situé au droit de chaque bande.

9. Interface haptique selon l'une des revendications précédentes, comportant des moyens de détection (13) pour détecter la position dudit au moins un organe et dans laquelle le module de commande (MC) est configuré pour générer les signaux de commande en en prenant en compte les signaux émis par les moyens de détection (13).

10. Interface haptique selon l'une des revendications précédentes, comportant des moyens de mesure (15) pour mesurer un effort exercé par ledit au moins un organe sur la surface d'interaction et dans laquelle le module de commande (MC) est configuré pour générer les signaux de commande en prenant en compte les signaux émis par les moyens de mesure (13).

11. Interface haptique selon l'une des revendications précédentes comportant plusieurs actionneurs et dans laquelle le module de commande (MC) est configuré pour générer des signaux de commande pour chaque actionneur individuellement.

12. Interface haptique selon l'une des revendications précédentes, dans laquelle le module de commande (MC) est configuré pour générer des signaux de commande combinant les signaux de commande aux premières fréquences et des signaux de commande à des deuxièmes fréquences non radiatives.

13. Interface haptique l'une des revendications 1 à 12, comportant un écran (16) disposé sous la plaque (4) à l'opposé de la surface d'interaction (6), ledit au moins un actionneur (A1) étant entre la plaque (4) et l'écran (16), ledit au moins un actionneur (A1) étant un actionneur piézoélectrique comportant des films minces transparents.

14. Interface haptique selon l'une des revendications 1 à 12, comportant un écran (16) fixé à la plaque (4) à l'opposé de la surface interaction (6), ledit écran (16) étant interposé entre la plaque (4) et ledit au moins un actionneur (A1).

15. Clavier d'ordinateur comportant des touches et au moins une interface haptique selon l'une des revendications précédentes.

16. Souris d'ordinateur comportant au moins une interface haptique selon l'une des revendications 1 à 14, ladite interface haptique étant configurée pour simuler au moins un clic.

## Patentansprüche

1. Haptische Schnittstelle, die einen Träger (2), mindestens eine Platte (4), die eine erste Seite umfasst, welche eine Fläche (6) zur Interaktion mit mindestens einem Glied eines Benutzers bildet, und mindestens einen Aktor (A1), der in der Lage ist, eine Vibration an die Platte (4) anzulegen, und ein Modul (MC) zum Steuern des Aktors umfasst,

   - wobei der Träger mindestens zwei Trägerelemente umfasst, die die Platte so tragen, dass zwischen den zwei Trägerelementen ein Streifen begrenzt wird, der sich im Wesentlichen entlang einer ersten Richtung (X) erstreckt,
   - wobei sich der Aktor (A1) in Bezug auf die Interaktionsfläche (6) der Platte (4) gegenüberliegend befindet,
   - wobei das Steuermodul (MC) dafür ausgelegt ist, Steuersignale für den Aktor (A1) mit ersten Frequenzen zu erzeugen, die niedriger sind als die Grenzfrequenz der ersten Ausbreitungsmode der Platte, sodass der Aktor (A1) evaneszente Wellen in der Platte (4) erzeugt.

2. Haptische Schnittstelle nach Anspruch 1, wobei die Platte (4) eine erste Abmessung (I) in der ersten Richtung (X) aufweist, und wobei der Abstand zwischen den zwei Trägerelementen mindestens doppelt so klein ist wie die erste Abmessung (I).

3. Haptische Schnittstelle nach Anspruch 2, wobei die Platte (4) in einer zur ersten Richtung (X) orthogonalen Richtung eine zweite Abmessung (L) zwischen seinen Seitenkanten aufweist, und wobei die Trägerelemente die Seitenkanten tragen, wobei die erste Abmessung (I) mindestens doppelt so groß ist wie die zweite Abmessung (L).

4. Haptische Schnittstelle nach einem der Ansprüche 1 bis 3, wobei die Platte (4) einfach vom Träger (2) getragen wird und/oder in den Träger (2) eingebettet ist.

5. Haptische Schnittstelle nach einem der Ansprüche 1 bis 4, wobei die Platte auf den Träger (2) geklebt ist.

**6.** Haptische Schnittstelle nach einem der Ansprüche 1 bis 5, wobei die Frequenz oder die Frequenzen der Steuersignale im Bereich zwischen 0 Hz und 10 kHz liegen.

**7.** Haptische Schnittstelle nach einem der Ansprüche 1 bis 6, die mindestens zwei entlang der ersten Richtung (X) verteilte Aktoren umfasst.

**8.** Haptische Schnittstelle nach einem der Ansprüche 1 bis 7, wobei der Träger mindestens drei Trägerelemente so umfasst, dass in der ersten Richtung (X) mindestens zwei Streifen in der Platte begrenzt werden, und wobei sich an jedem Streifen mindestens ein Aktor befindet.

**9.** Haptische Schnittstelle nach einem der vorstehenden Ansprüche, die Erkennungsmittel (13) umfasst, um die Position des mindestens einen Gliedes zu erkennen, und wobei das Steuermodul (MC) dafür ausgelegt ist, die Steuersignale unter unter Berücksichtigung der von den Erkennungsmitteln (13) ausgegebenen Signale zu erzeugen.

**10.** Haptische Schnittstelle nach einem der vorstehenden Ansprüche, die Messmittel (15) umfasst, um eine Kraft, die von dem mindestens einen Glied auf die Interaktionsfläche ausgeübt wird, zu messen, und wobei das Steuermodul (MC) dafür ausgelegt ist, die Steuersignale unter Berücksichtigung der von den Messmitteln (13) ausgegebenen Signale zu erzeugen.

**11.** Haptische Schnittstelle nach einem der vorstehenden Ansprüche, die mehrere Aktoren umfasst, und wobei das Steuermodul (MC) dafür ausgelegt ist, Steuersignale für jeden Aktor einzeln zu erzeugen.

**12.** Haptische Schnittstelle nach einem der vorstehenden Ansprüche, wobei das Steuermodul (MC) dafür ausgelegt ist, Steuersignale zu erzeugen, die die Steuersignale mit den ersten Frequenzen und Steuersignale mit zweiten, nicht ausstrahlenden Frequenzen kombinieren.

**13.** Haptische Schnittstelle einem der Ansprüche 1 bis 12, die einen Bildschirm (16) umfasst, der unter der Platte (4) der Interaktionsfläche (6) gegenüberliegend angeordnet ist, wobei sich der mindestens eine Aktor (A1) zwischen der Platte (4) und dem Bildschirm (16) befindet, wobei es sich bei dem mindestens einen Aktor (A1) um einen piezoelektrischen Aktor handelt, der transparente Dünnschichten umfasst.

**14.** Haptische Schnittstelle nach einem der Ansprüche 1 bis 12, die einen Bildschirm (16) umfasst, der der Interaktionsfläche (6) gegenüberliegend an der Platte (4) befestigt ist, wobei der Bildschirm (16) zwischen der Platte (4) und dem mindestens einen Aktor (A1) eingefügt ist.

**15.** Computertastatur, die Tasten und mindestens eine haptische Schnittstelle nach einem der vorstehenden Ansprüche umfasst.

**16.** Computermaus, die mindestens eine haptische Schnittstelle nach einem der Ansprüche 1 bis 14 umfasst, wobei die haptische Schnittstelle dafür ausgelegt ist, mindestens einen Klick zu simulieren.

**Claims**

**1.** A haptic interface including a support (2), at least one plate (4) comprising a first face forming a surface (6) for interaction with at least one member of a user, and at least one actuator (A1) adapted to apply a vibration to said plate (4), and a control module (MC) of said actuator,

- said support including at least two support elements supporting the plate so as to delimit between the two support elements a strip extending substantially along a first direction (X),
- said actuator (A1) being located opposite to the plate (4) with respect to the interaction surface (6),
- said control module (MC) being configured to generate control signals to said actuator (A1) at first frequencies lower than the cutoff frequency of the first propagation mode of said plate, so that the actuator (A1) generates evanescent waves in the plate (4).

**2.** The haptic interface according to claim 1, wherein the plate (4) has a first dimension (I) in the first direction (X) and wherein the distance between the two support elements is at least twice smaller than the first dimension (I).

3. The haptic interface according to claim 2, wherein the plate (4) has a second dimension (L) in a direction orthogonal to the first direction (X) between its lateral edges, and wherein the support elements support the lateral edges, the first dimension (I) being at least twice larger than the second dimension (L).

4. The haptic interface according to one of claims 1 to 3, wherein the plate (4) is simply supported by the support (2) and/or embedded to the support (2).

5. The haptic interface according to one of claims 1 to 4, wherein the plate is glued on the support (2).

6. The haptic interface according to one of claims 1 to 5, wherein the frequency(ies) of the control signals are comprised between O Hz and 10 kHz.

7. The haptic interface according to one of claims 1 to 6, including at least two actuators distributed along the first direction (X).

8. The haptic interface according to one of claims 1 to 7, wherein the support includes at least three support elements so as to delimit at least two strips in the plate in the first direction (X), and wherein at least one actuator is located upright each strip.

9. The haptic interface according to one of the preceding claims, including detection means (13) to detect the position of said at least one member and wherein the control module (MC) is configured to generate the control signals while taking into account the signals emitted by the detection means (13).

10. The haptic interface according to one of the preceding claims, including measuring means (15) to measure a force exerted by said at least one member on the interaction surface and wherein the control module (MC) is configured to generate the control signals while taking into account the signals emitted by the measuring means (13).

11. The haptic interface according to one of the preceding claims, including several actuators and wherein the control module (MC) is configured to generate control signals for each actuator individually.

12. The haptic interface according to one of the preceding claims, wherein the control module (MC) is configured to generate control signals combining the control signals at the first frequencies and control signals at second non-radiating frequencies.

13. The haptic interface according to one of claims 1 to 12, including a screen (16) disposed under the plate (4) opposite to the interaction surface (6), said at least one actuator (A1) being between the plate (4) and the screen (16), said at least one actuator (A1) being a piezoelectric actuator including transparent thin films.

14. The haptic interface according to one of claims 1 to 12, including a screen (16) fastened to the plate (4) opposite to the interaction surface (6), said screen (16) being interposed between the plate (4) and said at least one actuator (A1).

15. A computer keyboard including keys and at least one haptic interface according to one of the preceding claims.

16. A computer mouse including at least one haptic interface according to one of claims 1 to 14, said haptic interface being configured to simulate at least one click.

FIG.1

FIG.2

FIG.3

FIG.4

FIG.5

FIG.6

FIG.7B

FIG.7A

FIG.8B

FIG.8A

FIG.9

FIG.10

FIG.11

FIG.12

## FIG.13A

104

X

## FIG.13B

104

X

## FIG.14

X

4

2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2464117 A

**Littérature non-brevet citée dans la description**

- **C. HUDIN.** Local friction modulation using non-radiating ultrasonic vibrations. *IEEE World Haptics Conférence, Fürstenfeldbruck (Munich), Germany,* 2017